# EUROPEAN PATENT APPLICATION

(11) **EP 4 641 853 A1**
(43) Date of publication of application: **29.10.2025**
(21) Application number: 23906474.4
(22) Date of filing: 27.10.2023
(51) Int. Cl.: H02G 1/10, G01K 1/14, H02G 9/00

(54) **DIAGNOSTIC METHOD, DIAGNOSTIC PROGRAM, AND DIAGNOSTIC DEVICE**

(30) Priority: 20.12.2022 JP 2022203631
(71) Applicant: Yokogawa Electric Corporation, Tokyo 180-8750 (JP)
(72) Inventor: MINATOYAMA Misaki, Musashino-shi, Tokyo 180-8750 (JP); NAKATSU Yuri, Musashino-shi, Tokyo 180-8750 (JP); KONADA Soichiro, Musashino-shi, Tokyo 180-8750 (JP); ANNEN Masato, Musashino-shi, Tokyo 180-8750 (JP)
(74) Representative: Stöckeler, Ferdinand
(86) International application number: PCT/JP2023/038980
(87) International publication number: WO 2024/135101

(57) **Abstract**

A diagnostic method for diagnosing the state of a cable (40) includes acquiring a measured temperature value at each of a diagnosis target portion and a portion other than the diagnosis target portion of the cable (40), and determining that the state of the diagnosis target portion of the cable (40) is abnormal in a case in which an amount of change in the temperature of each of the diagnosis target portion and the portion other than the diagnosis target portion of the cable (40) satisfies a diagnostic condition applied to diagnosis based on a change over time in the temperature of each of the diagnosis target portion and the portion other than the diagnosis target portion of the cable (40), and the temperature of the diagnosis target portion satisfies a diagnostic condition applied to diagnosis based on the temperature of the diagnosis target portion of the cable (40).

## Description

### CROSS-REFERENCE TO RELATED APPLICATION

The present application claims priority to Japanese Patent Application No. 2022-203631 filed on December 20, 2022, the entire contents of which are incorporated herein by reference.

### TECHNICAL FIELD

The present disclosure relates to a diagnostic method, a diagnostic program, and a diagnostic apparatus for diagnosis of the state of a submarine cable.

### BACKGROUND

Conventional methods are known for monitoring submarine cables by calculating the thermal resistance of the ground surrounding a submarine cable based on the change over time in the temperature and electric current of the submarine cable and estimating the covering height of the submarine cable based on the thermal resistance of the ground (see, for example, Patent Literature (PTL) 1).

### CITATION LIST

### Patent Literature

PTL 1: JP 2016-201989 A

### SUMMARY

### (Technical Problem)

The state of a cable is determined not only by the height of the soil and the like on the ground covering the cable when the cable is buried in the seabed, but also by a variety of other factors, such as damage to the cable's outer sheath or breakage of the cable. Various factors must be considered in diagnosing the state of the cable.

It is an aim of the present disclosure, conceived in light of the above, to provide a diagnostic method, a diagnostic program, and a diagnostic apparatus that can improve the accuracy of diagnosis of the state of a cable.

### (Solution to Problem)

(1) A diagnostic method according to several embodiments is a diagnostic method for diagnosing a state of a cable including a diagnosis target portion and a portion other than the diagnosis target portion. The diagnosis target portion corresponds to a part of a measurement target portion for measuring a temperature of the cable. The portion other than the diagnosis target portion corresponds to a different measurement target portion than the measurement target portion corresponding to the diagnosis target portion. The diagnostic method includes acquiring a measured temperature value at the measurement target portion corresponding to the diagnosis target portion of the cable as a temperature of the diagnosis target portion of the cable, acquiring a measured temperature value at the measurement target portion corresponding to the diagnosis target portion of the cable as a temperature of the portion other than the diagnosis target portion of the cable, and determining that a state of the diagnosis target portion is abnormal in a case in which an amount of change in the temperature of each of the diagnosis target portion and the portion other than the diagnosis target portion of the cable satisfies a diagnostic condition applied to diagnosis based on a change over time in the temperature of each of the diagnosis target portion and the portion other than the diagnosis target portion of the cable, and the temperature of the diagnosis target portion satisfies a diagnostic condition applied to diagnosis based on the temperature of the diagnosis target portion of the cable. In this way, the state of each portion of the cable is continuously diagnosed. In addition, the influence of environmental changes is reduced in the diagnosis of the state of each portion of the cable. The accuracy of diagnosis of the state of each portion of the cable is thereby improved.
(2) The diagnostic method according to an embodiment may, in (1), include determining, after determining that the amount of change in the temperature of each of the diagnosis target portion and the portion other than the diagnosis target portion satisfies the diagnostic condition applied to diagnosis based on the change over time in the temperature of each of the diagnosis target portion and the portion other than the diagnosis target portion of the cable, whether the temperature of the diagnosis target portion satisfies the diagnostic condition applied to diagnosis based on the temperature of the diagnosis target portion of the cable. In this way, the state of each portion of the cable is continuously diagnosed. In addition, the influence of environmental changes is reduced in the diagnosis of the state of each portion of the cable. The accuracy of diagnosis of the state of each portion of the cable is thereby improved.
(3) The diagnostic method according to an embodiment may, in (2), include changing the portion other than the diagnosis target portion to a different portion of the cable so that the amount of change in the temperature of each of the diagnosis target portion and the portion other than the diagnosis target portion of the cable satisfies the diagnostic condition applied to diagnosis based on the change over time in the temperature of each of the diagnosis target portion and the portion other than the diagnosis target portion of the cable. In this way, the state of the cable 40 is diagnosed assuming different geologies even without geological data. The accuracy of diagnosis of the state of the cable 40 is thereby improved.
(4) As an embodiment, in any one of (1) to (3), the diagnostic condition applied to diagnosis based on the change over time in the temperature of each of the diagnosis target portion and the portion other than the diagnosis target portion of the cable may include a condition based on a value that represents the state of the diagnosis target portion taking into consideration a state of the portion other than the diagnosis target portion of the cable, the value being calculated based on the amount of change in each of the temperature of the diagnosis target portion of the cable and the temperature of the portion other than the diagnosis target portion of the cable. The diagnostic condition applied to diagnosis based on the temperature of the diagnosis target portion of the cable may include a condition based solely on the change over time in the temperature of the diagnosis target portion. In this way, the influence of environmental changes is reduced in the diagnosis of the state of each portion of the cable. The accuracy of diagnosis of the state of each portion of the cable is thereby improved.
(5) As an embodiment, in (4), the condition based solely on the change over time in the temperature of the diagnosis target portion may include the temperature of the diagnosis target portion of the cable being outside a determination range. The determination range may be set based on a magnitude of an electric current flowing in the cable and an environment surrounding the diagnosis target portion of the cable. In this way, the influence of environmental changes is reduced in the diagnosis of the state of each portion of the cable. The accuracy of diagnosis of the state of each portion of the cable is thereby improved.
(6) As an embodiment, in (4) or (5), the value that represents the state of the diagnosis target portion taking into consideration the state of the portion other than the diagnosis target portion of the cable may be calculated as an absolute value of a difference between a value obtained by multiplying the amount of change in the temperature of the diagnosis target portion of the cable by a coefficient corresponding to the diagnosis target portion of the cable and a value obtained by multiplying the amount of change in the temperature of the portion other than the diagnosis target portion of the cable by a coefficient corresponding to the portion other than the diagnosis target portion of the cable. The coefficient corresponding to the diagnosis target portion of the cable may be set based on an environment surrounding the diagnosis target portion of the cable. The coefficient corresponding to the portion other than the diagnosis target portion of the cable may be set based on an environment surrounding the portion other than the diagnosis target portion of the cable. The condition based on the value that represents the state of the diagnosis target portion taking into consideration the state of the portion other than the diagnosis target portion of the cable may include the value that represents the state of the diagnosis target portion taking into consideration the state of the portion other than the diagnosis target portion of the cable being equal to or greater than a determination value. The determination value may be set based on the coefficient corresponding to the diagnosis target portion of the cable and the coefficient corresponding to the portion other than the diagnosis target portion of the cable. In this way, the influence of environmental changes is reduced in the diagnosis of the state of each portion of the cable. The accuracy of diagnosis of the state of each portion of the cable is thereby improved.
(7) As an embodiment, in any one of (4) to (6), the value that represents the state of the diagnosis target portion taking into consideration the state of the portion other than the diagnosis target portion of the cable may be corrected based on a difference between a time at which the temperature of the diagnosis target portion of the cable begins to change and a time at which the temperature of the portion other than the diagnosis target portion of the cable begins to change. In this way, the state of each portion of the cable is diagnosed taking into consideration the heat generated by the cable 40. The accuracy of diagnosis of the state of the cable is thereby improved.
(8) A diagnostic program according to several embodiments is configured to cause a computer to execute the diagnostic method according to any one of (1) to (7). In this way, the state of each portion of the cable is continuously diagnosed. In addition, the influence of environmental changes is reduced in the diagnosis of the state of each portion of the cable. The accuracy of diagnosis of the state of each portion of the cable is thereby improved.
(9) A diagnostic apparatus according to several embodiments includes a controller configured to execute the diagnostic method according to any one of (1) to (7). In this way, the state of each portion of the cable is continuously diagnosed. In addition, the influence of environmental changes is reduced in the diagnosis of the state of each portion of the cable. The accuracy of diagnosis of the state of each portion of the cable is thereby improved.

### (Advantageous Effect)

According to the diagnostic method, diagnostic program, and diagnostic apparatus of the present disclosure, the accuracy of diagnosis of the state of a cable is improved.

### BRIEF DESCRIPTION OF THE DRAWINGS

In the accompanying drawings:
FIG. 1 is a schematic diagram illustrating an example configuration of a diagnostic system according to an embodiment;
FIG. 2 is a block diagram illustrating an example configuration of a diagnostic system according to an embodiment;
FIG. 3 is a schematic diagram illustrating an example configuration of a cable;
FIG. 4A is a cross-sectional diagram illustrating an example of a cable buried underground;
FIG. 4B is a cross-sectional diagram illustrating an example of a cable that is nearly exposed to the seabed;
FIG. 5 is a flowchart illustrating example procedures of a diagnostic method according to an embodiment;
FIG. 6 is a schematic diagram illustrating an example configuration of a cable that passes through a plurality of different geologies;
FIG. 7 is a diagram illustrating an example of the relationship between the burial state of the cable and the temperature distribution;
FIG. 8A is a graph illustrating an example of the time variation in the heat generation temperature of the cable;
FIG. 8B is a graph illustrating an example of the time variation in the temperature at point X of the cable; and
FIG. 8C is a graph illustrating an example of the time variation in the temperature at point Y of the cable.

### DETAILED DESCRIPTION

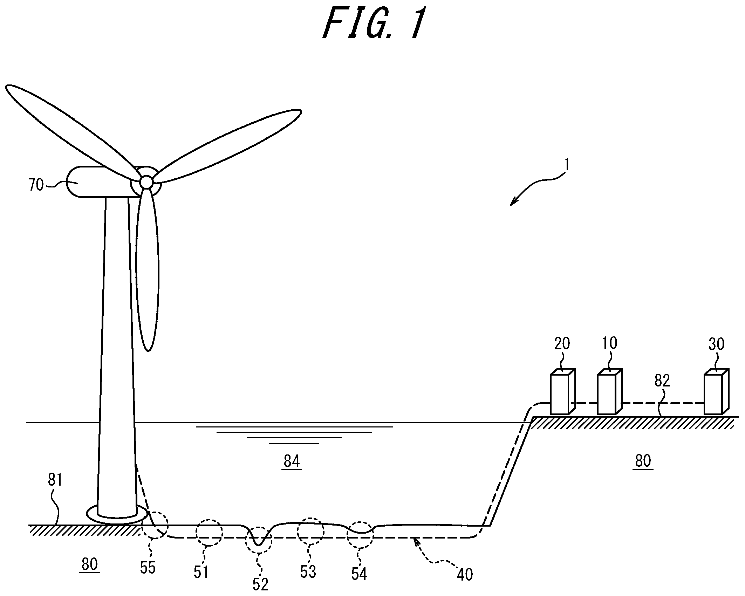

A diagnostic system 1 (see FIG. 1) according to one embodiment of the present disclosure diagnoses the state of a submarine cable connected to an offshore wind power generation apparatus or the like. The embodiment of the diagnostic system 1 is described below while being contrasted with a comparative example.

### (Comparative Example)

As a comparative example, a method of diagnosing a submarine cable by visual confirmation by a diver, or by sonar or an apparatus such as a Remotely Operated Vehicle (ROV), may be considered. The diagnostic method according to the comparative example is not a method that can be executed all the time, but rather is executed only once a year or once every few years, for example. The state of a submarine cable may suddenly change because of natural phenomena including scouring due to ocean currents or typhoons, or sedimentation due to earthquakes, or because of human activities, including contact with anchors or fishing gear, or other reasons. The diagnostic method according to the comparative example cannot immediately detect sudden changes in the state of a submarine cable. The inability to immediately detect changes in the state of submarine cables makes it difficult to identify the cause of a change in state. In addition, if the submarine cable generates heat due to bending or the like, the amount of electricity that can be transmitted may be limited, or the submarine cable itself may deteriorate, due to the undetected change in state. Heat generation also increases power loss.

Another problem with the diagnostic method according to the comparative example is the cost or time required to perform the diagnosis. In addition, the diagnostic method according to the comparative example cannot be executed when the ocean conditions are rough due to bad weather or the like. In addition, in the diagnosis method according to the first comparative example, the accuracy of diagnosis based on visual confirmation is reduced due to the adhesion of sediment or marine organisms to the portion where the submarine cable is buried.

The present disclosure therefore describes a diagnostic system 1 (see FIG. 1) that can continuously, easily, or without the need for visual inspection, diagnose various states of a submarine cable, such as the height of the soil and the like on the ground covering the submarine cable when the submarine cable is buried in the seabed, damage to the outer sheath of the submarine cable, breakage of the submarine cable, or the like.

### (Embodiment of Present Disclosure)

As illustrated in FIG. 1, the diagnostic system 1 according to an embodiment includes the diagnostic apparatus 10, a temperature measurement apparatus 20, and a display apparatus 30. The diagnostic system 1 diagnoses the state of the cable 40.

In the present embodiment, the cable 40 is a submarine cable buried in the ground 80 so as to pass through a seabed 81 for use in transporting the electricity generated by the offshore wind power generation apparatus 70 to land 82, for communication between the offshore wind power generation apparatus 70 and equipment such as the diagnostic apparatus 10 on land 82, or for various other uses. The destination to which the cable 40 transports electricity or to which the cable 40 is connected for communication is not limited to equipment on land 82, but may be equipment that is offshore, in the sea, or the like.

Depending on the unevenness of the seabed 81, the cable 40 includes portions that are buried under the ground 80 and portions that are exposed from under the ground 80 into the sea 84 due to the seabed 81 being excavated. The portion buried in the ground 80 is illustrated as a buried portion 51 and a buried portion 53. The portion exposed from under the ground 80 into the sea 84 is illustrated as an exposed portion 52. The cable 40 includes portions that are not exposed in the sea 84 but have a shallow burial depth under the ground 80. The portion having a shallow burial depth under the ground 80 is illustrated as a shallow buried portion 54.

The exposed portion 52 or shallow buried portion 54 may be caused by the seabed 81 becoming concave due to a phenomenon called scouring, in which the seabed 81 is eroded by ocean currents. The exposed portion 52 or shallow buried portion 54 may also be caused by the cable 40 being lifted upwards due to movement of the seabed 81 caused by an earthquake or the like.

The cable 40 includes a portion that is drawn from under the ground 80 into the sea 84 for connection to the offshore wind power generation apparatus 70. The portion that is drawn from under the ground 80 into the sea 84 is illustrated as a boundary portion 55.

Submarine cables are susceptible to bending or damage due to collisions with fishing gear, anchors, or the like against the exposed portion 52 or shallow buried portion 54. The diagnostic system 1 may diagnose whether the submarine cable is in an exposed state or a state near exposure into the sea 84.

The temperature of a submarine cable differs between when it is buried under the ground 80 and when it is exposed or nearly exposed into the sea 84. Therefore, in the diagnostic system 1 according to the present embodiment, the temperature measurement apparatus 20 measures the temperature of at least a portion of the cable 40. Based on the temperature of at least a portion of the cable 40, the diagnostic apparatus 10 diagnoses whether the cable 40 is buried under the ground 80 or exposed into the sea 84 as the state of the cable 40. The diagnostic apparatus 10 may diagnose the state of heat generation in the cable 40 as well as the burial state of the cable 40. The display apparatus 30 displays the result of diagnosis of the state of the cable 40.

### (Example Configuration of Diagnostic System 1)

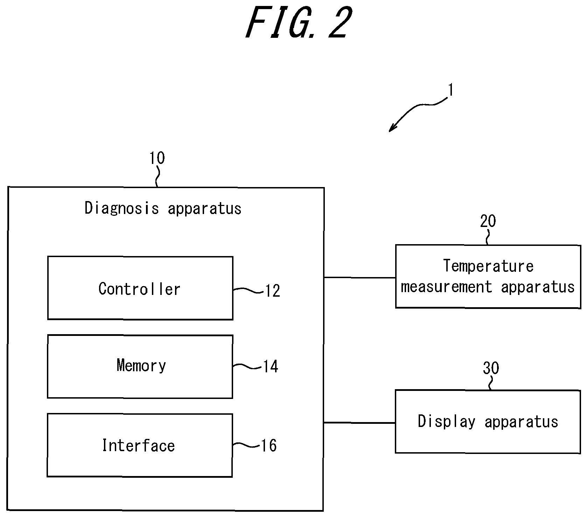

An example configuration of the diagnostic system 1 illustrated in FIG. 2 is described below.

### <Diagnostic Apparatus 10>

The diagnostic apparatus 10 diagnoses the state of the cable 40 based on the temperature of each portion of the cable 40 measured by the temperature measurement apparatus 20 and displays the diagnosis result on the display apparatus 30, as described below. The measurement of the temperature of each portion of the cable 40 is based on the assumption that a fiber connected to the cable 40 is used as a sensor, as described below. In the case of measuring the temperature of each portion of the cable 40 along the longitudinal direction of the cable 40, the fiber that runs along the cable 40 and is connected to the temperature measurement apparatus 20 serves as a sensor. In a case in which the cable 40 is a submarine cable, a free fiber among the fibers enclosed in the cable 40 may be used as a sensor, as described below.

The diagnostic apparatus 10 includes a controller 12, a memory 14, and an interface 16.

The controller 12 controls each component of the diagnostic apparatus 10. The controller 12 may, for example, be configured by a processor such as a central processing unit (CPU). The controller 12 may implement predetermined functions by having the processor execute a predetermined program.

The memory 14 may store various information used for operations of the controller 12, programs for implementing the functions of the controller 12, and the like. The memory 14 may function as a working memory of the controller 12. The memory 14 may, for example, be a semiconductor memory. The memory 14 may be configured to include volatile memory or non-volatile memory. The memory 14 may be configured as a non-transitory computer-readable storage medium. The memory 14 may be included in the controller 12.

The memory 14 may store information at the time of burial of the cable 40. The information at the time of burial of the cable 40 may include the burial position or burial depth of the cable 40 when the cable 40 was successfully buried. The information at the time of burial of the cable 40 may include the measured temperature value of each portion of the cable 40 when no electric current is flowing in the cable 40 immediately after the cable 40 has been successfully buried or immediately after maintenance has successfully been performed on the cable 40. The information at the time of burial of the cable 40 may include information about the geology of the location where the cable 40 was buried. The information about the geology may include the soil type or the geothermal conductivity. The memory 14 may store information after the cable 40 is buried. The information after burial of the cable 40 may include the measured temperature value of each portion of the cable 40 when electric current is flowing in the cable 40. The information after burial of the cable 40 may include data relating the magnitude of the electric current flowing in the cable 40, the magnitude of the voltage applied to the cable 40, and the temperature of each portion of the cable 40. The memory 14 may include characteristics of the temperature measurements in the cable 40.

The interface 16 is configured to include a communication device that communicably connects the diagnostic apparatus 10 with the temperature measurement apparatus 20, the display apparatus 30, or the like. The communication device may be configured to communicate based on a mobile communication standard, such as 4^{th} Generation (4G), Long Term Evolution (LTE), or 5^{th} Generation (5G). The communication device may be configured to be capable of communication based on a communication standard such as Local Area Network (LAN). The communication device may be configured to be capable of wired or wireless communication.

The interface 16 may be configured to include a display device. The display device may include various types of displays, such as a liquid crystal display. The interface 16 may be configured to include an audio output device, such as a speaker. The interface 16 is not limited to these examples and may be configured to include various other output devices.

The interface 16 may be configured to include an input device that accepts input from the user. The input device may, for example, include a keyboard or physical keys, a touch panel or touch sensor, or a pointing device such as a mouse. The interface 16 may be configured to include other calculators or diagnostic apparatuses 10. The input device is not limited to these examples and may be configured to include a variety of other devices. The input device may be configured to allow input of parameters and the like for the diagnostic apparatus 10 to diagnose the state of the cable 40.

The diagnostic apparatus 10 may be configured as a Personal Computer (PC) or as at least one server apparatus. The diagnostic apparatus 10 may be realized in a cloud computing system.

### <Temperature Measurement Apparatus 20>

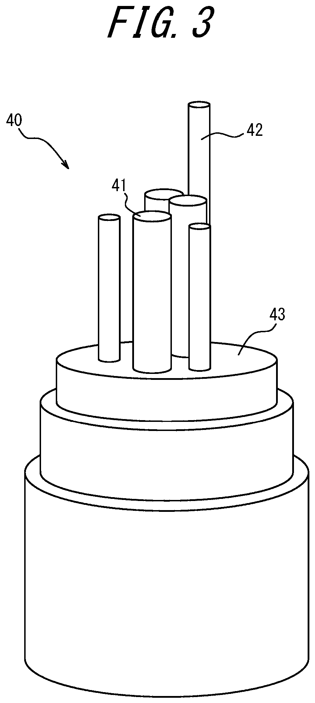

The temperature measurement apparatus 20 measures the temperature of at least a portion of the cable 40. The portion of the cable 40 whose temperature is to be measured by the temperature measurement apparatus 20 is also referred to as the measurement target portion. In order for the diagnostic system 1 to diagnose the burial state, disconnection state, and the like of a long cable 40 in its entirety, the temperature needs to be measured for a large number of portions of the cable 40, i.e., hundreds, thousands, or more points in the cable 40. The measurement target portions may be set at predetermined intervals along the longitudinal direction of the cable 40, such as at 1 m intervals, or at indefinite intervals. In the present embodiment, the cable 40 is assumed to include a power line 41, an optical fiber 42, and a sheath 43, as illustrated in FIG. 3. The power line 41 and the optical fiber 42 are protected inside the sheath 43. In the present embodiment, the temperature measurement apparatus 20 uses the optical fiber 42 to measure the temperature of each portion of the cable 40 in the longitudinal direction. The optical fiber 42 used for temperature measurement is also referred to as a Distributed Temperature Sensor (DTS).

Specifically, the temperature measurement apparatus 20 transmits pulsed light into the optical fiber 42. The pulsed light that enters the optical fiber 42 is scattered by Raman scattering at various positions in the optical fiber 42. The scattered light yielded by Raman scattering is also referred to as Raman scattered light. At least a portion of the Raman scattered light returns to the entrance side of the optical fiber 42. The temperature measurement apparatus 20 acquires a signal that is based on the Raman scattered light returning to the entrance side of the fiber.

The Raman scattered light includes Stokes light that is shifted to longer wavelengths from the wavelength of the incident pulsed light and anti-Stokes light that is shifted to shorter wavelengths from the wavelength of the incident pulsed light. The intensity of each component of the Raman scattered light depends on the temperature of the optical fiber 42 at the position where the Raman scattering occurred. The temperature measurement apparatus 20 can calculate the temperature of the optical fiber 42 at the position where the optical signal was scattered by analyzing the Raman scattered light that is reflected and returns. Based on the time from when an optical signal is transmitted until the optical signal is reflected and returns, the temperature measurement apparatus 20 can also calculate the position where the received optical signal was reflected. Accordingly, the temperature measurement apparatus 20 can calculate the temperature of the optical fiber 42 at each position of the optical fiber 42.

The temperature of each portion of the optical fiber 42 is considered to be approximately the same as the temperature of each portion of the cable 40 corresponding to each portion of the optical fiber 42. The temperature measurement apparatus 20 can measure the temperature of each portion of the cable 40 by measuring the temperature of each portion of the optical fiber 42. In the present embodiment, it is assumed that the temperature of each portion of the cable 40 is measured at 1 meter intervals. The interval at which the temperature is measured is not limited to 1 meter and may be set to various lengths.

The temperature measurement apparatus 20 may be configured to measure the temperature of each measurement target portion of the cable 40 using temperature sensors, other than the optical fiber 42, installed at each temperature measurement target portion of the cable 40. The temperature sensors may be mounted on the outside of the sheath 43 of the cable 40 or may be embedded within the sheath 43. The temperature sensors may be mounted on connectors of the cable 40.

The temperature measurement apparatus 20 is not limited to a measurement method using the optical fiber 42 or a measurement method using temperature sensors and may be configured to measure the temperature of the measurement target portions of the cable 40 using various other methods.

### <Display Apparatus 30>

The display apparatus 30 displays the result of diagnosis of the state of the cable 40 by the diagnostic apparatus 10. The display apparatus 30 may display various data, including the results of temperature measurement of at least a portion of the cable 40, the change over time in the results of temperature measurement, or the like. The display apparatus 30 may include various types of displays, such as a liquid crystal display. The display apparatus 30 may be included in the diagnostic apparatus 10 as the display device of the interface 16 of the diagnostic apparatus 10. The diagnostic apparatus 10, the temperature measurement apparatus 20, and the display apparatus 30 may be configured integrally. Some combination of the diagnostic apparatus 10, the temperature measurement apparatus 20, and the display apparatus 30 may be configured integrally. The diagnostic apparatus 10, the temperature measurement apparatus 20, and the display apparatus 30 may each be configured separately.

The diagnostic system 1 may include a speaker that outputs the result of diagnosing the state of the cable 40 by audio, or may include various other output devices. As the device for outputting the result of diagnosing the state of the cable 40, the diagnostic system 1 may include another output device in addition to the display apparatus 30 or may include another output device instead of the display apparatus 30.

### (Operation Example of Diagnostic System 1)

As described above, in the diagnostic system 1 according to the present embodiment, the diagnostic apparatus 10 can diagnose the state of the diagnosis target portion of the cable 40 based on the measured temperature value of the measurement target portion of the cable 40.

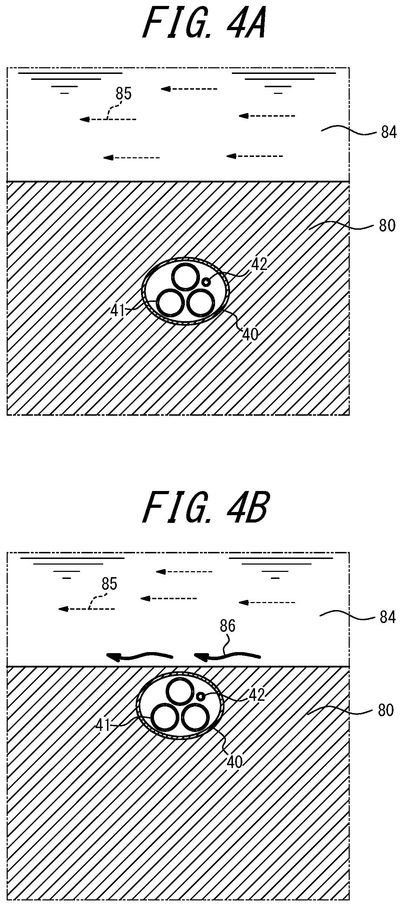

For example, as illustrated in FIGS. 4A and 4B, the amount of heat transferred from the cable 40 into the sea 84 depends on the burial depth of the cable 40 under the ground 80. As illustrated in FIG. 4A, when the cable 40 is buried deep in the ground 80, the amount of heat lost from the cable 40 by an ocean current 85 in the sea 84 is less. On the other hand, if the cable 40 is about to be exposed from the ground 80 to the sea 84, or if the cable 40 is exposed to the sea 84, as illustrated in FIG. 4B, the amount of heat lost from the cable 40 due to an ocean current 86, which is a portion of the ocean current 85 in the sea 84 close to the cable 40, is greater. The reduction of sediment on the cable 40 due to the burial anomaly of the cable 40 causes the cable 40 to be closer to or in contact with seawater. The cable 40 loses heat to seawater when the cable 40 is close to or in contact with seawater. As the cable 40 loses heat to seawater, the temperature of the portion of the cable 40 that is close to or in contact with seawater is relatively lower than the temperature of the portion where the cable 40 is normally buried. Therefore, it is determined that the diagnosis target portion of the cable 40 with a lower temperature is in a state of abnormal burial, where heat is lost to seawater and the amount of sediment on the cable 40 is reduced. In comparing FIG. 4A and FIG. 4B, the closer the burial position of the diagnosis target portion the cable 40 is to being in the sea 84, the lower the temperature of the diagnosis target portion of the cable 40. Therefore, the diagnostic apparatus 10 can diagnose the burial position of each portion of the cable 40 based on the temperature of each portion of the cable 40.

If the cable 40 is bent or damaged, the resistance of the power line 41 of the cable 40 can increase. The increased resistance of the power line 41 increases the amount of heat generated at the bent or damaged portion. The temperature of the portion of the cable 40 with increased heat generation will be higher. Therefore, the diagnostic apparatus 10 can diagnose abnormalities such as bends or damage occurring in each portion of the cable 40 based on the temperature of each portion of the cable 40.

The diagnostic apparatus 10 is not limited to diagnosing abnormalities at the burial position of the cable 40, or abnormalities such as bends or damage in the cable 40, but can also diagnose various other states of the cable 40. An operation example of the diagnostic system 1 is described below.

### <Diagnosis Based on Temperature of Diagnosis Target Portion of Cable 40>

The controller 12 of the diagnostic apparatus 10 acquires the measured temperature value of the portion of the cable 40 that is the diagnosis target from the temperature measurement apparatus 20. The portion that is the diagnosis target is also referred to as the diagnosis target portion.

The controller 12 determines that the state of the diagnosis target portion of the cable 40 is normal in a case in which the temperature of the diagnosis target portion of the cable 40 is within a predetermined temperature range. The controller 12 determines that the state of the diagnosis target portion of the cable 40 is abnormal in a case in which the temperature of the diagnosis target portion of the cable 40 is not within the predetermined temperature range. The predetermined temperature range to be compared with the temperature of the diagnosis target portion of the cable 40 is also referred to as the determination range. In a case in which the temperature of the cable 40 decreases as the burial position of the cable 40 is shallower, the controller 12 may set only the lower limit of the determination range and not set the upper limit of the determination range. Conversely, in a case in which the temperature of the cable 40 increases as the burial position of the cable 40 is shallower, the controller 12 may set only the upper limit of the determination range and not set the lower limit of the determination range.

The controller 12 may set the determination range based on the magnitude of the electric current flowing in the cable 40. For example, the controller 12 may set the determination range so that the median value of the determination range is higher as the electric current flowing in the cable 40 is greater.

The controller 12 may set the determination range based on environmental conditions of the ground 80 at the position where the diagnosis target portion of the cable 40 is buried or the environment in the sea 84 near the position where the diagnosis target portion of the cable 40 is buried. For example, the controller 12 may set the determination range based on the geology of the position where the diagnosis target portion of the cable 40 is buried. The controller 12 may set the determination range so that the median value of the determination range is lower as the thermal conductivity of the geology in which the diagnosis target portion of the cable 40 is buried is higher. For example, the controller 12 may set the determination range based on the seawater temperature near the position where the diagnosis target portion of the cable 40 is buried. The controller 12 may set the determination range so that the median value of the determination range is lower as the seawater temperature is lower. For example, the controller 12 may set the determination range based on the depth of the position where the diagnosis target portion of the cable 40 is buried. The controller 12 may set the determination range so that as the position where the diagnosis target portion of the cable 40 is buried is deeper, the temperature width of the determination range narrows in consideration of how the temperature of the diagnosis target portion of the cable 40 is less likely to change. In other words, the controller 12 may set the determination range based on the magnitude of the electric current flowing in the cable 40 and the environment surrounding the diagnosis target portion of the cable 40.

The controller 12 may set the determination range based on the measured temperature value of the diagnosis target portion of the cable 40 when the diagnosis target portion of the cable 40 was initially buried. The controller 12 may set the determination range based on the measured temperature value of the diagnosis target portion of the cable 40 when the state of the diagnosis target portion of the cable 40 was most recently confirmed to be normal. The controller 12 may set the determination range based on the measured temperature value of the boundary portion 55 where the cable 40 is drawn from the ground 80 into the sea 84. The controller 12 may set the determination range based on a statistical value such as an average value of the values obtained by measuring the temperature of the diagnosis target portion of the cable 40 over a predetermined period of time. The determination range is not limited to these examples and may be set based on various other information.

The controller 12 may calculate values representing the state of the diagnosis target portion of the cable 40, such as the occurrence of an abnormality in the burial state of the cable 40 at the diagnosis target portion of the cable 40, based on the temperature of the diagnosis target portion of the cable 40. The occurrence of a burial abnormality may cause an accident or hazardous event in the operation of the equipment or in activities in the vicinity of the equipment, such as a portion of the cable 40 exposed from the seabed being caught and damaged by an anchor or the like. Therefore, the value that represents the state of the diagnosis target portion of the cable 40 is also referred to as the danger level. As the state of the diagnosis target portion of the cable 40 is closer to abnormal, the controller 12 calculates the danger level as a higher value. As the state of the diagnosis target portion of the cable 40 is closer to normal, the controller 12 calculates the danger level as a lower value. The controller 12 may diagnose that the state of the diagnosis target portion of the cable 40 is abnormal in a case in which the danger level is equal to or greater than a predetermined threshold. The predetermined threshold used to determine the danger level is also referred to as the danger level threshold.

The danger level may be calculated as a normalized value in a range between 0 and 1. The controller 12 may calculate the value of the danger level representing the state of the diagnosis target portion of the cable 40 as 1 when the diagnosis target portion of the cable 40 is in a normal state of being buried sufficiently deep in the ground 80, and may calculate the value of the danger level to be greater than 1 as the diagnosis target portion of the cable 40 is buried at a shallower position. The expression of the value of the danger level is not limited to these examples. As long as the degree of danger of the state of the cable 40 is recognized, the value of the danger level may be expressed in any way, including percentages and the like. In the following description, it is assumed that the value of the danger level is expressed as a normalized value between 0 and 1, with the value being closer to 0 as the state of the diagnosis target portion of the cable 40 is closer to normal and closer to 1 as the state of the diagnosis target portion of the cable 40 is closer to abnormal.

The controller 12 may, for example, output a warning indicating that the diagnosis target portion of the cable 40 is still buried, but that the burial position is getting shallower and approaching exposure to the sea 84, in a case in which the danger level is 0.5 or higher. The controller 12 may, for example, determine that the diagnosis target portion of the cable 40 is exposed to the sea 84 in a case in which the danger level is 0.95 or higher and output information indicating that the state of the diagnosis target portion of the cable 40 has become abnormal. The controller 12 may, for example, calculate the danger level to be 0.5 when the burial depth of the diagnosis target portion of the cable 40 is about 50 cm. The controller 12 may set a danger level threshold corresponding to each of a plurality of stages so that the state of the diagnosis target portion of the cable 40 can be diagnosed in a plurality of stages according to the abnormality level. The values such as 0.5 or 0.95 calculated by the controller 12 as the value of the danger level in response to the abnormal state or other state of the cable 40 are not limited to these values. The controller 12 may set the value of the danger level according to the abnormal state or other state of the cable 40 as appropriate.

In order to diagnose the state of a plurality of portions of the cable 40, the controller 12 may set a plurality of diagnosis target portions of the cable 40 and diagnose the state of each of the diagnosis target portions of the cable 40. The controller 12 may set different determination ranges for at least some of the diagnosis target portions of the cable 40. The controller 12 may set the same determination range for at least some of the diagnosis target portions of the cable 40.

As described above, the state of the diagnosis target portion of the cable 40 is diagnosed based on the measured temperature value of the diagnosis target portion of the cable 40. In this way, the state of each portion of the cable 40 is continuously diagnosed.

The controller 12 may separately set a determination range or danger level threshold for diagnosing a state in which the cable 40 is exposed to the sea 84 and a determination range or danger level threshold for diagnosing a state in which the cable 40 is bent or damaged. In this way, the controller 12 can separately diagnose whether the state of the cable 40 is abnormal exposure to the sea 84 or an abnormality such as bending or breakage.

### <Diagnosis Based on Change over Time in Temperature of Plurality of Portions of Cable 40>

In the diagnostic system 1 according to the present embodiment, the diagnostic apparatus 10 may perform diagnosis based on the change over time in the temperature of a plurality of portions of the cable 40. Immediately after the cable 40 is laid, for example, the cable 40 is considered to be buried over the entire area. Even if a temperature that is determined to be an abnormal value is measured in this state, the cable 40 state may be diagnosed with that temperature as the correct value.

The controller 12 of the diagnostic apparatus 10 acquires the measured temperature value of the plurality of portions of the cable 40 from the temperature measurement apparatus 20. The controller 12 acquires, as the temperature of the plurality of portions of the cable 40, the measured temperature value of the diagnosis target portion for which the state is to be diagnosed and the measured temperature value of a portion other than the diagnosis target portion. The diagnosis target portion of the cable 40 corresponds to a part of a measurement target portion for measuring the temperature of the cable 40. The portion other than the diagnosis target portion of the cable 40 corresponds to a different measurement target portion than the measurement target portion corresponding to the diagnosis target portion of the cable 40. The controller 12 acquires the measured temperature value at the measurement target portion corresponding to the diagnosis target portion of the cable 40 as the temperature of the diagnosis target portion of the cable 40. The controller 12 acquires the measured temperature value at the measurement target portion corresponding to the portion other than the diagnosis target portion of the cable 40 as the temperature of the portion other than the diagnosis target portion of the cable 40. The portion other than the diagnosis target portion of the cable 40 may be a portion that is separated from the diagnosis target portion of the cable 40 by a predetermined distance along the cable 40. The portion that is the portion other than the diagnosis target portion of the cable 40 during a certain period may be the diagnosis target portion of the cable 40 during another period. The portion that is the diagnosis target portion of the cable 40 during a certain period may be the portion other than the diagnosis target portion of the cable 40 during another period. In a case in which the environment in which the cable 40 is buried changes as a whole, it is assumed that the temperature of each of the portions of the cable 40 will change under the influence of the change in the environment. The controller 12 can diagnose the state of the diagnosis target portion of the cable 40 by comparing the amount of change in the temperature of the diagnosis target portion of the cable 40 with the amount of change in the temperature of the portion other than the diagnosis target portion of the cable 40.

The controller 12 may, for example, diagnose that the state of the diagnosis target portion of the cable 40 has changed in a case in which the temperature of the diagnosis target portion of the cable 40 has changed while the temperature of the portion other than the diagnosis target portion of the cable 40 is unchanged. The controller 12 may, for example, determine that the state of the diagnosis target portion of the cable 40 has changed in a case in which the amount of change in the temperature of the diagnosis target portion of the cable 40 is greater than the amount of change in the temperature of the portion other than the diagnosis target portion of the cable 40 before and after the passage of a predetermined time. The controller 12 may diagnose that the state of the diagnosis target portion of the cable 40 has become abnormal in a case in which the amount of change in the temperature of the diagnosis target portion of the cable 40 is equal to or greater than a predetermined threshold. The predetermined threshold to be compared with the amount of change in the temperature of the diagnosis target portion of the cable 40 is also referred to as the amount of change threshold.

The controller 12 may, for example, calculate a value that represents the state of the diagnosis target portion taking into consideration the state of the portion other than the diagnosis target portion of the cable 40, based on the amount of change in each of the temperature of the diagnosis target portion and the temperature of the portion other than the diagnosis target portion of the cable 40. The value that represents the state of the diagnosis target portion taking into consideration the state of the portion other than the diagnosis target portion of the cable 40 is a value that takes into consideration the relationship between the measured temperature value of the portion other than the diagnosis target portion and a reference value when determining the danger level according to the relationship between the measured temperature value of the diagnosis target portion and a reference value. The controller 12 may diagnose whether the state of the diagnosis target portion of the cable 40 has become abnormal based on the value that represents the state of the diagnosis target portion of the cable 40 taking into consideration the state of the portion other than the diagnosis target portion of the cable 40. The controller 12 may, for example, diagnose that the state of the diagnosis target portion of the cable 40 has become abnormal in a case in which the value that represents the state of the diagnosis target portion of the cable 40 taking into consideration the state of the portion other than the diagnosis target portion of the cable 40 is equal to or greater than the determination value.

The controller 12 may calculate the value that represents the state of the diagnosis target portion of the cable 40 taking into consideration the state of the portion other than the diagnosis target portion of the cable 40 based on, for example, a weighted value for each of the amount of change in the temperature of the diagnosis target portion and the amount of change in the temperature of the portion other than the diagnosis target portion. The controller 12 may weight the amount of change in the temperature of the diagnosis target portion by multiplying the amount of change by a coefficient corresponding to the diagnosis target portion. The controller 12 may set the coefficient corresponding to the diagnosis target portion based on the environment surrounding the position where the diagnosis target portion of the cable 40 is buried. The controller 12 may weight the amount of change in the temperature of the portion other than the diagnosis target portion by multiplying the amount of change by a coefficient corresponding to the portion other than the diagnosis target portion. The controller 12 may set the coefficient corresponding to the portion other than the diagnosis target portion based on the environment surrounding the position where the portion other than the diagnosis target portion of the cable 40 is buried. In other words, the controller 12 may calculate the value that represents the state of the diagnosis target portion of the cable 40 taking into consideration the state of the portion other than the diagnosis target portion of the cable 40 as the absolute value of the difference between a value obtained by multiplying the amount of change in the temperature of the diagnosis target portion by a coefficient corresponding to the diagnosis target portion and a value obtained by multiplying the amount of change in the temperature of the portion other than the diagnosis target portion by a coefficient corresponding to the portion other than the diagnosis target portion. The controller 12 may set the determination value for the value that represents the state of the diagnosis target portion of the cable 40 taking into consideration the state of the portion other than the diagnosis target portion of the cable 40 based on the coefficient corresponding to the diagnosis target portion and the coefficient corresponding to the portion other than the diagnosis target portion.

As described above, the controller 12 can diagnose the state of the diagnosis target portion of the cable 40 based on the change over time in the temperature of each of the diagnosis target portion and the portion other than the diagnosis target portion of the cable 40. In this way, the influence of environmental changes is reduced in the diagnosis of the state of each portion of the cable 40.

The controller 12 may separately perform setting of the amount of change threshold or the determination value for the value that represents the state of the diagnosis target portion of the cable 40 taking into consideration the state of the portion other than the diagnosis target portion of the cable 40 for diagnosing the state in which the cable 40 is exposed to the sea 84, and setting of the amount of change threshold or the determination value for the value that represents the state of the diagnosis target portion of the cable 40 taking into consideration the state of the portion other than the diagnosis target portion of the cable 40 for diagnosing the state in which the cable 40 is bent or damaged. In this way, the controller 12 can separately diagnose whether the state of the cable 40 is abnormal exposure to the sea 84 or an abnormality such as bending or breakage.

The number of portions other than the diagnosis target portion with which the controller 12 compares the change over time in the temperature of the diagnosis target portion is not limited to one. The controller 12 may diagnose the state of the diagnosis target portion of the cable 40 by comparing the change over time in the temperature of two or more portions other than the diagnosis target portion with the change over time in the temperature of one diagnosis target portion.

### <Combination of Diagnostic Methods>

The controller 12 may diagnose that the state of the diagnosis target portion of the cable 40 may be abnormal by a diagnosis based on the change over time in the temperature of each of the diagnosis target portion and the portion other than the diagnosis target portion of the cable 40. The controller 12 may diagnose whether the state of the diagnosis target portion of the cable 40 is abnormal based solely on the change over time in the temperature of the diagnosis target portion of the cable 40 after diagnosing that the state of the diagnosis target portion of the cable 40 may be abnormal.

The controller 12 may diagnose that the state of the diagnosis target portion of the cable 40 may be abnormal based solely on the change over time in the temperature of the diagnosis target portion of the cable 40. The controller 12 may diagnose whether the state of the diagnosis target portion of the cable 40 is abnormal by a diagnosis based on the change over time in the temperature of each of the diagnosis target portion and the portion other than the diagnosis target portion of the cable 40 after diagnosing that the state of the diagnosis target portion of the cable 40 may be abnormal.

As a comparative example, assume that the controller 12 monitors only the change over time in the measured temperature value at one diagnosis target portion of the cable 40 and determines that there may be an abnormality in that diagnosis target portion in a case in which the temperature at that diagnosis target portion has risen. It may not be possible, however, to conclude that there is an abnormality in a certain diagnosis target portion of the cable 40 just because the temperature at the diagnosis target portion has risen. For example, in a case in which the temperature of the entire cable 40 has risen due to power transmission of the cable 40 or the like, a rise in the temperature of one diagnosis target portion of the cable 40 means that the temperature of the adjacent diagnosis target portions or other diagnosis target portions has also risen. If the temperature of the entire cable 40 has risen, then the controller 12 does not determine that there is an abnormality in one diagnosis target portion of the cable 40 based on a rise in temperature at that diagnosis target portion.

Therefore, in the diagnostic system 1 according to the present disclosure, the controller 12 does not immediately determine that a certain diagnosis target portion of the cable 40 is abnormal even if the temperature at that diagnosis target portion has risen, but rather checks the temperatures of a portion other than the diagnosis target portion. As the temperature of a portion other than the diagnosis target portion, the controller 12 may, for example, check the temperature of the measurement target portion adjacent to the measurement target portion with the temperature corresponding to the diagnosis target portion, or the temperature of another measurement target portion located within a predetermined distance from the diagnosis target portion. If the temperature of the portion other than the diagnosis target portion has not risen when the temperature of the diagnosis target portion has risen, the controller 12 may determine that the temperature has changed only in the diagnosis target portion and that there is an abnormality in the diagnosis target portion. If the temperature of the portion other than the diagnosis target portion has risen when the temperature of the diagnosis target portion has risen, the controller 12 checks the range over which the temperature has risen in the same manner as the diagnosis target portion. In a case in which the controller 12 can identify the range over which the temperature rises in the same manner as the diagnosis target portion, the controller 12 may determine that there is an abnormality in the cable 40 within that range.

As described above, the controller 12 checks not only the temperature of the diagnosis target portion of the cable 40 but also the temperature of a portion other than the diagnosis target portion. This reduces the likelihood of an abnormality in the diagnosis target portion of the cable 40 being diagnosed incorrectly, as compared to the case of checking only the temperature of the diagnosis target portion of the cable 40. In other words, the accuracy of diagnosis of an abnormality in the diagnosis target portion of the cable 40 is improved.

The controller 12 may diagnose whether the state of the diagnosis target portion of the cable 40 is abnormal by performing a diagnosis based solely on the change over time in the temperature of the diagnosis target portion of the cable 40 after performing a diagnosis based on the change over time in the temperature of each of the diagnosis target portion and the portion other than the diagnosis target portion of the cable 40. The controller 12 may diagnose whether the state of the diagnosis target portion of the cable 40 is abnormal by performing a diagnosis based on the change over time in the temperature of each of the diagnosis target portion and the portion other than the diagnosis target portion of the cable 40 after performing a diagnosis based solely on the change over time in the temperature of the diagnosis target portion of the cable 40. In other words, the controller 12 may diagnose whether the state of the diagnosis target portion of the cable 40 is abnormal by performing a diagnosis combining the diagnosis based on the change over time in the temperature of each of the diagnosis target portion and the portion other than the diagnosis target portion of the cable 40 and the diagnosis based solely on the change over time in the temperature of the diagnosis target portion of the cable 40. In this way, the accuracy of diagnosis of the state of each portion of the cable 40 is improved.

In the diagnosis based on the change over time in the temperature of each of the diagnosis target portion and the portion other than the diagnosis target portion of the cable 40, the controller 12 may determine whether the change over time in the temperature of each of the diagnosis target portion and the portion other than the diagnosis target portion satisfies a diagnostic condition applied to diagnosis based on the change over time in the temperature of each of the diagnosis target portion and the portion other than the diagnosis target portion of the cable 40. The diagnostic condition applied to diagnosis based on the change over time in the temperature of each of the diagnosis target portion and the portion other than the diagnosis target portion of the cable 40 may include a condition based on a value that represents the state of the diagnosis target portion taking into consideration the state of the portion other than the diagnosis target portion of the cable 40, the value being calculated based on the amount of change in each of the temperature of the diagnosis target portion of the cable 40 and the temperature of the portion other than the diagnosis target portion of the cable 40. The diagnostic condition applied to diagnosis based on the change over time in the temperature of each of the diagnosis target portion and the portion other than the diagnosis target portion of the cable 40 may include that the temperature of the diagnosis target portion of the cable 40 has changed while the temperature of the portion other than the diagnosis target portion of the cable 40 is unchanged. The diagnostic condition applied to diagnosis based on the change over time in the temperature of each of the diagnosis target portion and the portion other than the diagnosis target portion of the cable 40 may include that the amount of change in the temperature of the diagnosis target portion of the cable 40 is greater than the amount of change in the temperature of the portion other than the diagnosis target portion of the cable 40 before and after the passage of a predetermined time. The diagnostic condition applied to diagnosis based on the change over time in the temperature of each of the diagnosis target portion and the portion other than the diagnosis target portion of the cable 40 may include that the amount of change in the temperature of the diagnosis target portion of the cable 40 is equal to or greater than the amount of change threshold. The diagnostic condition applied to diagnosis based on the change over time in the temperature of each of the diagnosis target portion and the portion other than the diagnosis target portion of the cable 40 may include that the value that represents the state of the diagnosis target portion of the cable 40 taking into consideration the state of the portion other than the diagnosis target portion of the cable 40 is equal to or greater than the determination value.

During the diagnosis based solely on the change over time in the temperature of the diagnosis target portion of the cable 40, the controller 12 may determine whether the temperature of the diagnosis target portion satisfies a diagnostic condition applied to diagnosis based solely on the change over time in the temperature of the diagnosis target portion of the cable 40. The diagnostic condition applied to diagnosis based solely on the change over time in the temperature of the diagnosis target portion of the cable 40 may include a condition based on the temperature of the diagnosis target portion of the cable 40. The diagnostic condition applied to diagnosis based solely on the change over time in the temperature of the diagnosis target portion of the cable 40 may include the temperature of the diagnosis target portion of the cable 40 being outside of the determination range. The diagnostic condition applied to diagnosis based on the temperature of the diagnosis target portion of the cable 40 may include the danger level calculated based on the temperature of the diagnosis target portion of the cable 40 being equal to or greater than the danger level threshold.

### <Output of Diagnostic Result>

The controller 12 may display the diagnostic results on the display apparatus 30. The controller 12 may output the diagnostic results in other forms, such as audio. The controller 12 may output the diagnostic results to report an abnormality in a case in which the state of a part of the cable 40 is diagnosed as abnormal. The controller 12 may output the diagnostic results even when the state of the cable 40 is diagnosed as normal.

The controller 12 may display, on the display apparatus 30, the measured temperature value of each portion of the cable 40 used in the diagnosis. The controller 12 may display, on the display apparatus 30, the change over time in the temperature of each portion of the cable 40. The controller 12 may display the danger level, the value that represents the state of the diagnosis target portion of the cable 40 taking into consideration the state of the portion other than the diagnosis target portion of the cable 40, or the like calculated during the diagnosis on the display apparatus 30. The controller 12 may display the measured temperature value of each portion of the cable 40 and the like in correspondence with the diagnostic result. Having a human, such as a worker managing the cable 40, a monitor, or an operator of the diagnostic apparatus 10, check the measured temperature value of each portion of the cable 40 together with the diagnostic results can enhance the diagnostic skills or knowledge of the human.

### <Example Procedures of Diagnostic Method>

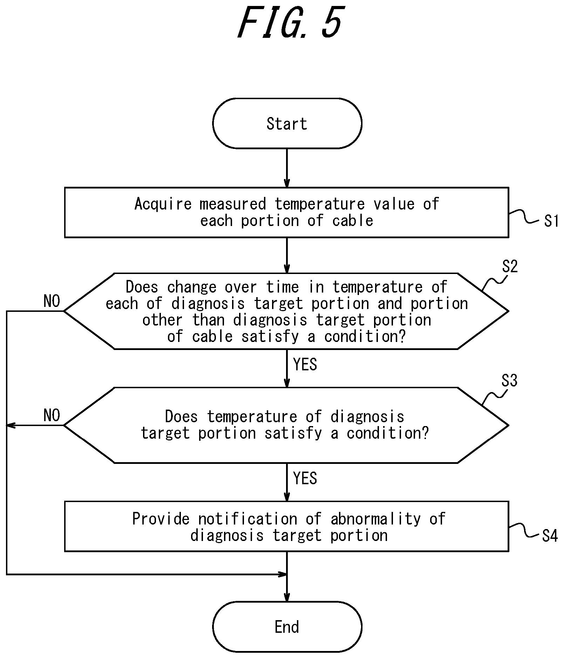

The controller 12 of the diagnostic apparatus 10 may execute a display method including the procedures in the flowchart illustrated in FIG. 5 to diagnose the state of the cable 40. The diagnostic method may be implemented as a display program executed by a processor or computer that configures the controller 12. The diagnostic program may be stored on a non-transitory computer readable medium.

The controller 12 acquires the measured temperature value of each of the diagnosis target portion and the portion other than the diagnosis target portion of the cable 40 from the temperature measurement apparatus 20 (step S1).

The controller 12 determines whether the change over time in the temperature of each of the diagnosis target portion and the portion other than the diagnosis target portion of the cable 40 satisfies a diagnostic condition applied to diagnosis based on the change over time in the temperature of each of the diagnosis target portion and the portion other than the diagnosis target portion of the cable 40 (step S2). In a case in which the change over time in the temperature of each of the diagnosis target portion and the portion other than the diagnosis target portion of the cable 40 does not satisfy the diagnostic condition (step S2: NO), the controller 12 diagnoses that the state of the diagnosis target portion of the cable 40 is not abnormal and terminates execution of the procedures in the flowchart of FIG. 5.

In a case in which the change over time in the temperature of each of the diagnosis target portion and the portion other than the diagnosis target portion of the cable 40 satisfies the diagnostic condition applied to diagnosis based on the change over time in the temperature of each of the diagnosis target portion and the portion other than the diagnosis target portion of the cable 40 (step S2: YES), the controller 12 determines whether the temperature of the diagnosis target portion of the cable 40 satisfies a diagnostic condition applied to diagnosis based on the temperature of the diagnosis target portion of the cable 40 in the diagnosis based on the temperature of the diagnosis target portion of the cable 40 (step S3). In a case in which the temperature of the diagnosis target portion of the cable 40 does not satisfy the diagnostic condition (step S3: NO), the controller 12 diagnoses that the state of the diagnosis target portion of the cable 40 is not abnormal and terminates execution of the procedures in the flowchart of FIG. 5.

In a case in which the temperature of the diagnosis target portion of the cable 40 satisfies the diagnostic condition (step S3: YES), the controller 12 determines that the state of the diagnosis target portion of the cable 40 is abnormal and provides notification of the abnormality of the diagnosis target portion of the cable 40 (step S4). After executing the procedure of step S4, the controller 12 ends execution of the procedures in the flowchart in FIG. 5.

In the procedures of the flowchart illustrated in FIG. 5, the controller 12 makes a diagnosis based on the change over time in the temperature of each of the diagnosis target portion and the portion other than the diagnosis target portion of the cable 40 prior to the diagnosis based on the temperature of the diagnosis target portion of the cable 40. The controller 12 may make a diagnosis based on the temperature of the diagnosis target portion of the cable 40 prior to the diagnosis based on the change over time in the temperature of each of the diagnosis target portion and the portion other than the diagnosis target portion of the cable 40. The controller 12 may make only one of the diagnosis based on the change over time in the temperature of each of the diagnosis target portion and the portion other than the diagnosis target portion of the cable 40 and the diagnosis based on the temperature of the diagnosis target portion of the cable 40.

### <Summary>

As described above, in the diagnostic system 1 according to the present embodiment, the diagnostic apparatus 10 can diagnose the state of each portion of the cable 40 based on the temperature of each portion of the cable 40. In this way, the state of each portion of the cable 40 is continuously diagnosed. The diagnostic apparatus 10 can also diagnose the state of each portion of the cable 40 based on the change over time in the temperature of a plurality of portions of the cable 40. In this way, the influence of environmental changes is reduced in the diagnosis of the state of each portion of the cable 40. The accuracy of diagnosis of the state of each portion of the cable 40 is thereby improved.

The diagnostic apparatus 10 can also separately diagnose whether the state of the cable 40 is abnormal exposure to the sea 84 or an abnormality such as bending or breakage. In this way, various states are diagnosed while being distinguished from each other. The accuracy of diagnosis of various states of the cable 40 is thereby improved.

According to the diagnostic system 1, the state of the cable 40 is diagnosed without the entity managing the cable 40 being on site. The entity managing the cable 40 is a human, such as a worker, a monitor, or an operator of the diagnostic apparatus 10. The frequency and cost of visits by humans to the site where the cable 40 is buried are reduced as a result. Furthermore, the reliability of the cable 40 is improved by the realization of constant diagnosis.

The diagnostic system 1 provides clear diagnostic criteria for the state of each portion of the cable 40. The reliability of the cable 40 is thereby improved.

The diagnostic system 1 sets the temperature measurement target portion at intervals of 1 meter, for example, so as to reduce the number of portions that are missed in monitoring within a long cable 40 that extends over hundreds or thousands of meters, and monitors the state of each portion of the cable 40. Although a sensor of the same length as the cable 40 is required to measure the temperature over the entire cable 40 in this manner, this is easily accomplished by installing the optical fiber 42 along the cable 40, since the optical fiber 42 acts as the sensor. Furthermore, a plurality of optical fibers 42 are enclosed in the submarine cable to begin with. Of the plurality of optical fibers 42, a free fiber that is not used for other functions is used as is as a temperature sensor. The diagnostic system 1 monitors for a portion at which the temperature has risen among the hundreds, thousands, or tens of thousands of measurement target portions existing along the cable 40. When finding a measurement target portion at which the temperature has risen, the diagnostic system 1 checks the temperature of the measurement target portion located adjacent to or near that measurement target portion to improve the accuracy of diagnosis.

In the diagnostic system 1 according to the embodiment described above, the controller 12 of the diagnostic apparatus 10 diagnoses whether the diagnosis target portion of the cable 40 is abnormal based on the change over time in the temperature of the diagnosis target portion of the cable 40. Assuming that there is no change in the overall environment, such as a change in seawater temperature, the measured temperature value of the diagnosis target portion of the cable 40 should not have changed from the reference value if the diagnosis target portion of the cable 40 is normal. The reference value is the measured temperature value when the diagnosis target portion of the cable 40 is normally buried and the cable 40 itself is normal. The change over time in the temperature of the diagnosis target portion of the cable 40 represents the degree to which the current measured temperature value deviates from the reference temperature measured during normal conditions. The change over time in the temperature of the diagnosis target portion of the cable 40 is the difference between the temperature at a certain time and the temperature at a predetermined time in the past from that time. Therefore, the controller 12 may diagnose whether the diagnosis target portion of the cable 40 is abnormal by comparing the temperature of the diagnosis target portion of the cable 40 with the reference value.

### (Other Embodiments)

Other embodiments are described below.

### <Diagnosis Assuming Geology>

The geology of the seabed 81 where the cable 40 is buried may not be uniform. For example, the geology where diagnosis target portion of the cable 40 is buried may differ from the geology where the portion other than the diagnosis target portion of the cable 40 is buried. The controller 12 of the diagnostic apparatus 10 may diagnose the state of each portion of the cable 40 assuming that the geology where a certain portion of the cable 40 is buried differs from the geology where another portion of the cable 40 is buried. The certain portion of the cable 40 is, for example, the diagnosis target portion. The other portion of the cable 40 is, for example, the portion other than the diagnosis target portion.

The current flowing in the cable 40 may cause the temperature of the entire cable 40 to rise. On the other hand, the range of the rise in temperature may differ for each portion of the cable 40. The range of the rise in temperature of the diagnosis target portion of the cable 40 may be determined by factors such as the environment in which the diagnosis target portion of the cable 40 is buried or the quality of the soil constituting the ground 80 where the diagnosis target portion of the cable 40 is buried. For example, the measured temperature value of the diagnosis target portion of the cable 40 may differ for each type of soil constituting the ground 80 where the diagnosis target portion of the cable 40 is buried.

In a case in which the measured temperature value at a certain time is 27°C and the measured temperature value one minute before was 25°C, the change in temperature over time may be expressed as a 2°C rise in 1 min, i.e., the amount of temperature change per minute. In a case in which the measured temperature value of a measurement target portion (N) with the temperature corresponding to a certain diagnosis target portion rises by 2°C in 1 min, the controller 12 does not immediately determine that the diagnosis target portion is abnormal, but instead checks the temperature of a portion other than the diagnosis target portion, such as the measurement target portion (N + 1) adjacent to the measurement target portion (N) with the temperature corresponding to the diagnosis target portion, or the next adjacent measurement target portion (N + 2). In a case in which the temperature has risen in all of the measurement target portions (N), (N+1), and (N+2), but the temperature of the next adjacent measurement target portion (N + 3) and the measurement target portion adjacent in the opposite direction (N - 1) has not risen, the controller 12 may determine that the cable 40 is abnormal at the temperature measurement target portions (N), (N + 1), and (N + 2) of the cable 40.

The standard for determining whether the change over time rise in temperature represents an abnormality in the cable 40 differs according to factors such as the environment in which the diagnosis target portion of the cable 40 is buried or the quality of the soil constituting the ground 80 where the diagnosis target portion of the cable 40 is buried. In other words, the controller 12 may assume that the environment in which the cable 40 is buried, the quality of the soil constituting the ground 80 where the diagnosis target portion of the cable 40 is buried, and the like are different when determining whether the temperature at each measurement target portion has increased.

The controller 12 may estimate a change in geology by comparing the change over time in the temperature of two adjacent points among the temperature measurement target portions of the cable 40. For example, the controller 12 may estimate that the two points are included in different geologies in a case in which the change in temperature at one point is different from the change in temperature at the adjacent point.

For example, assume that the measured temperature value at a temperature measurement target portion (N) of a normally buried cable 40 is 25°C, the measured temperature value at the adjacent measurement target portions (N + 1) to (N + 5) is 25°C, and the measured temperature value at the next adjacent measurement target portion (N + 6) is 27°C. In this case, the controller 12 may estimate that the geology where the cable 40 is buried has changed between the measurement target portions (N + 5) and (N + 6). The controller 12 is not limited to changes in geology but may also estimate that other environments have changed.

For example, assume that the reference temperature at the measurement target portions (N) to (N + 5) is 25°C. Assume that the measured temperature value at the measurement target portions (N) to (N + 5) is 27°C. In this case, the temperature has risen by 2°C in the measurement target portions (N) to (N + 5). On the other hand, assume that the reference temperature and the measured temperature value at the measurement target portions (N + 6) to (N + 100) is 27°C. In this case, the temperature has not risen in the measurement target portions (N + 6) to (N + 100). Based on these temperature measurement results, the controller 12 may determine that an abnormality has occurred at the measurement target portions (N) to (N + 5).

Geological data is vast and is obtained deep underwater, making it difficult to obtain. As described above, the controller 12 can determine the state of the diagnosis target portion of the cable 40 by assuming the geology without using the geological data itself and without being explicitly aware of the geology. In a case in which geological data can be obtained, the controller 12 may determine whether the change over time in the temperature of each diagnosis target portion of the cable 40 corresponds to an abnormality based on the geological data. The controller 12 measures the temperature of each measurement target portion of the cable 40 via a fiber. Taking a certain measurement target portion as the diagnosis target portion, the controller 12 compares the temperature of the diagnosis target portion with the temperature of the surrounding measurement target portions, i.e., a portion other than the diagnosis target portion, and based on the relationship, may estimate a point of change in the environment, or the geology that is part of the environment, and make a determination taking into account the temperature difference conditions for each area.

Even in cases in which geological data is only partially acquired, or there are concerns about the accuracy of the geological data, or no geological data can be acquired at all, the controller 12 sets a reference temperature for designating each measurement target portion as a diagnosis target portion based on the temperature of each measurement target portion of the cable 40 at the time when the cable 40 is normally buried. The time when the cable 40 is normally buried corresponds to a time such as before the start of operation or immediately after maintenance. The controller 12 may estimate that the range including the measurement target portions for which the measured temperature values are the same when the cable 40 is normally buried is the range where the environmental conditions are the same or the geology is the same. In the example above, the range including the measurement target portions (N) to (N + 5) is estimated to be a certain geology with a reference temperature set at 25°C. The range including the measurement target portions (N + 6) to (N + 100) is a different geology with a reference temperature set at 27°C. After time has passed since operation of the cable 40 begins and the cable 40 is normally buried, and changes may occur in the state in which cable 40 is buried or in the state of cable 40 itself, the controller 12 designates each measurement target portion as a diagnosis target portion and determines whether the diagnosis target portion is abnormal, based on the reference temperature set for each measurement target portion.

In a case in which there exists a measurement target portion whose measured temperature value has reached 27°C within the range including the measurement target portion whose reference temperature is 25°C, the controller 12 determines that the temperature of the diagnosis target portion has increased when that measurement target portion is taken as the diagnosis target portion, and determines that the diagnosis target portion is abnormal. On the other hand, in a case in which there exists a measurement target portion whose measured temperature value has reached 27°C within the range including the measurement target portion whose reference temperature is 27°C, the controller 12 determines that the temperature of the diagnosis target portion has not changed when that measurement target portion is taken as the diagnosis target portion, and determines that the diagnosis target portion is not abnormal.

In comparing the measured temperature values at the plurality of measurement target portions, the controller 12 may compare the measured temperature values at adjacent measurement target portions, considering that the geology and environment of adjacent measurement target portions are likely to be the same. The comparison of measured temperature values at the plurality of measurement target portions may, for example, include a comparison of the temperature of the diagnosis target portion and the temperature of the portion other than the diagnosis target portion. On the other hand, the controller 12 may record the address (N + x) of the measurement target portions for which the measured temperature value under normal conditions was 25°C, even if they are not necessarily adjacent, and compare the measured temperature values among the measurement target portions for which the measured temperature values under normal conditions were the same. In other words, the controller 12 may find abnormal measurement target portions with a deviant measured temperature value among the measurement target portions for which the measured temperature value should be 25°C under normal conditions.

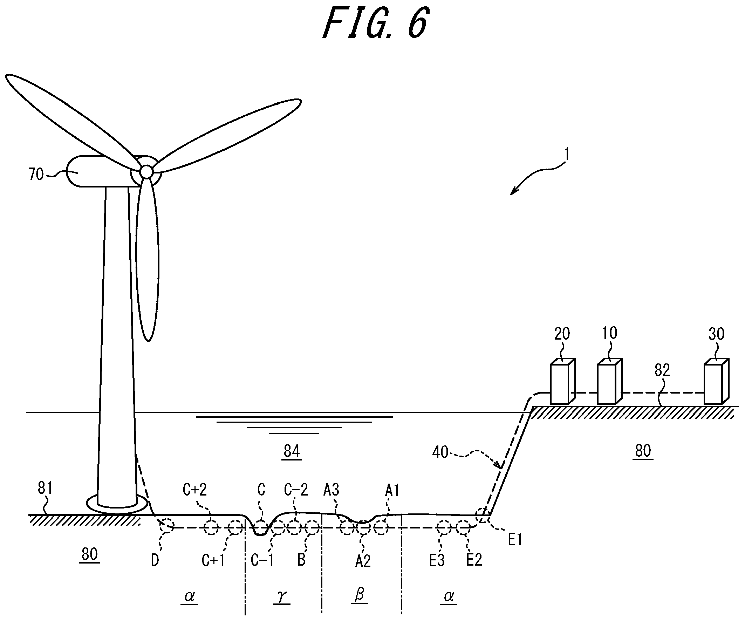

As illustrated in FIG. 6, assume that the cable 40 is buried so as to traverse a portion of geology α, a portion of geology β, and a portion of geology γ. The controller 12 does not need to know the data of the different geologies in which the cable 40 is buried. Assume that the temperature of the cable 40 buried in geology α is 25°C under normal conditions. Assume that the temperature of the cable 40 buried in geology β is 27°C under normal conditions. Assume that the temperature of the cable 40 buried in geology γ is 23°C under normal conditions. The controller 12 may acquire the temperature under normal conditions of each portion of the cable 40 as the measured temperature value when the cable 40 was first buried. The controller 12 may consider the differences in the temperature of each portion of the cable 40 under normal conditions to be due to differences in the geology in which the cable 40 is buried or differences in the environment other than the geology, or may not associate the differences in temperature with any factor.

Assume that the controller 12 estimates that A1, A2, and A3 are included in geology β. The controller 12 may acquire the temperature of each of the portions A1, A2, and A3 estimated to be included in geology β. Assume that the temperature at A2 is 25°C, which is lower than the temperature under normal conditions of 27°C in geology β. Assume that the temperature at A1 and A3 is 27°C, the temperature under normal conditions. In this case, the controller 12 may diagnose that the state of the portion of the cable 40 corresponding to A2 is abnormal. In a case in which the temperature at A1 is 26°C, which is lower than the temperature under normal conditions, the controller 12 may diagnose whether the abnormality in the state of the portion of cable 40 corresponding to A2 extends only to the part corresponding to A1 or extends to a portion farther away from A2 than A1 by comparing the temperature of the portion farther away from A2 with the temperature under normal conditions.

Assume that the controller 12 estimates that C, C - 1, and C - 2 are included in geology γ. Assume that the controller 12 estimates that C, C + 1, and C + 2 are included in geology α. The controller 12 may acquire the temperature of each of the portions C, C - 1, and C - 2 estimated to be included in geology γ. The controller 12 may also acquire the temperature of each of the portions C, C + 1, and C + 2 estimated to be included in geology α adjacent to geology γ. Assume that the temperature of geology γ under normal conditions is 23°C. Assume that the temperature at C is 20°C, which is lower than the temperature of geology γ under normal conditions (23°C). Assume that the temperature at C - 1 and C - 2 is the temperature of geology γ under normal conditions (23°C). Assume that the temperature of geology α under normal conditions is 25°C. Assume that the temperature at C + 1 and C + 2 is the temperature of geology α under normal conditions (25°C). In this case, the controller 12 may diagnose that the state of the portion of the cable 40 corresponding to C is abnormal. The controller 12 may diagnose that the state of the portion of the cable 40 corresponding to C - 1 is normal based on how the temperature at C - 1 is the same as the temperature at C - 2. The controller 12 may also diagnose that the state of the portion of the cable 40 corresponding to C + 1 is normal based on how the temperature at C + 1 is the same as the temperature at C + 2. In other words, for diagnosis regarding C, the controller 12 may change the portion other than the diagnosis target portion to a different portion of the cable 40 so that the amount of change in the temperature of each of the diagnosis target portion and the portion other than the diagnosis target portion satisfies the diagnostic condition applied to diagnosis based on the change over time in the temperature of each of the diagnosis target portion and the portion other than the diagnosis target portion of the cable 40. In this way, the state of the cable 40 is diagnosed assuming the geology. The accuracy of diagnosis of the state of the cable 40 is thereby improved.

The controller 12 may acquire the temperature of the portion D estimated to be included in geology α. Assume that the temperature of the portion D is the temperature of geology α under normal conditions (25°C). In this case, the controller 12 may diagnose that the state of the portion of the cable 40 corresponding to D is normal. The controller 12 may acquire the temperature of the portion B included in geology γ. Assume that the temperature of the portion B is the temperature of geology γ under normal conditions (23°C). In this case, the controller 12 may diagnose that the state of the portion of the cable 40 corresponding to B is normal.

The controller 12 may acquire the temperature at each of the portions E1, E2, and E3, which are estimated to be included in geology α and are close to the portion of the cable 40 raised to land 82. The temperature at E1, the burial start point, is close to the temperature of seawater. Assume that the temperature at each of E2 and E3 is the temperature of geology α under normal conditions (25°C). In this case, the controller 12 may diagnose that the state of the portions of the cable 40 corresponding to E2 and E3 is normal. The portion of the cable 40 that is raised to land 82 is less susceptible to the effects of fishing gear, anchors, or the like. The controller 12 may diagnose a change in the environment of the region where the cable 40 is buried based on the change over time in the temperature of at least one of the portions E2 or E3. The controller 12 may diagnose a change in the electric current flowing in the cable 40 based on the change over time in the temperature of at least one of the portions E1, E2, or E3.

### <Diagnosis Taking into Consideration Heat Generation of Cable 40>

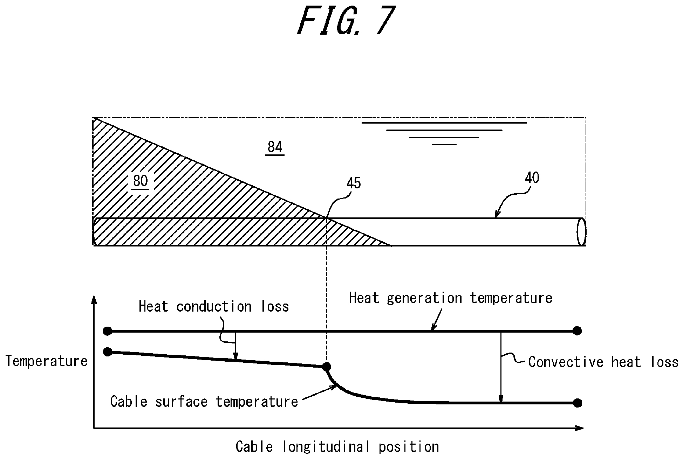

As illustrated in FIG. 7, in a case in which the overall temperature of the cable 40 increases due to electric current flowing in the cable 40, the surface temperature of the cable 40 is determined by the magnitude of heat loss in each portion of the cable 40. In the graph in FIG. 7, the horizontal axis represents the position in the longitudinal direction of the cable 40. The vertical axis represents the temperature. The graph labeled cable heat generation temperature represents the temperature of the diagnosis target portion of the cable 40 when there is no heat loss. The graph labeled cable surface temperature represents the decreased temperature due to heat loss and exhibits variation having an exposure start portion 45, where the cable 40 begins to be exposed to the sea 84, as a boundary. In the portion of the graph that is buried in the ground 80 to the left of the exposure start portion 45, the cable surface temperature is lower by the amount of heat conduction loss determined according to the depth at which the cable 40 is buried. In the portion of the graph exposed to the sea 84 to the right of the exposure start portion 45, the cable surface temperature is lower by the convective heat loss determined according to the area of the surface of the cable 40 exposed to the sea 84.

The controller 12 may identify the exposure start portion 45 of the cable 40 based on the temperature change in the longitudinal direction of the cable 40. The controller 12 may calculate the depth at which the cable 40 is buried based on the temperature change in the longitudinal direction of the cable 40. The controller 12 may calculate the percentage of the area of the surface of the cable 40 that is exposed to the sea 84 based on the temperature change in the longitudinal direction of the cable 40.

The cable 40 may be laid so that it is not buried in the ground 80 but rather exposed to the sea 84 on the seabed 81 and protected by wave-dissipating blocks, gravel, or the like placed over the cable 40. In this case, the cable 40 may be cooled by convective heat loss due to seawater entering through the gaps in the wave-dissipating blocks, gravel, or the like. The controller 12 may diagnose the state of the cable 40 taking into consideration changes in heat generation due to changes in the electric current flowing through the cable 40.

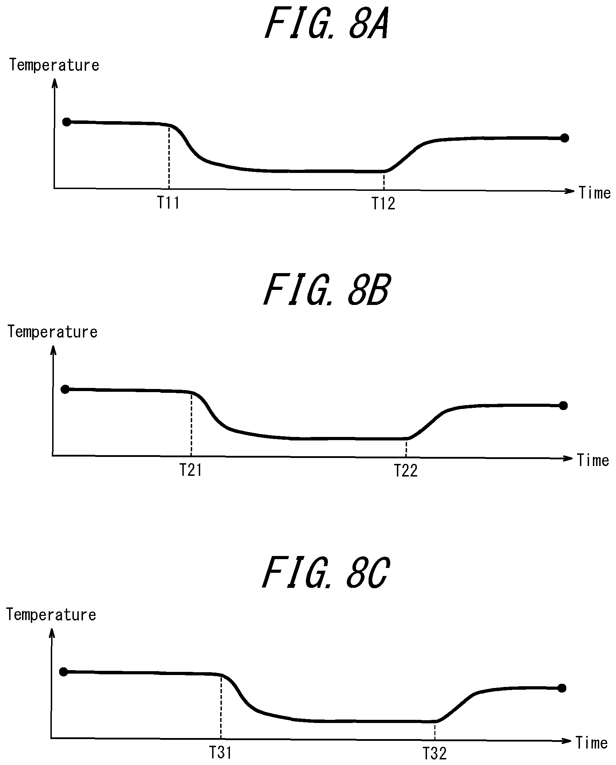

The controller 12 calculates the heat generation temperature of the cable 40, in the absence of heat loss, based on the change over time in the electric current in the cable 40, as illustrated in FIG. 8A. In the graph in FIG. 8A, the horizontal axis represents time. The vertical axis represents the temperature. Assume that from time T11, the heat generation temperature begins to lower as the current flowing through the cable 40 begins to decrease. Assume that from time T12, the heat generation temperature begins to rise as the current flowing through the cable 40 begins to increase.

The controller 12 acquires the change over time in the measured temperature value at point X of the cable 40, as illustrated in FIG. 8B. The controller 12 also acquires the change over time in the measured temperature value at point Y of the cable 40, as illustrated in FIG. 8C. In the graphs of FIGS. 8B and 8C, the horizontal axis represents time. The vertical axis represents the temperature. The temperature at point X of the cable 40 begins to decrease from time T21 and begins to increase from time T22. The temperature at point Y of the cable 40 begins to decrease from time T31 and begins to increase from time T32. Assume that times T31 and T32 are later than times T21 and T22.

The difference between the timing of the temperature change at point X and the timing of the temperature change at point Y is due to the difference in heat dissipation characteristics such as the amount of heat dissipation or the thermal capacity of the geology at each location. The controller 12 may calculate the geothermal conductivity of each location based on the differences in the heat dissipation characteristics of each location. The geothermal conductivity is determined based on the properties of the materials constituting the geology, the structure or density of the geology, or the like. The controller 12 may correct the danger level of each portion of the cable 40, the value that represents the state of the diagnosis target portion of the cable 40 taking into consideration the state of the portion other than the diagnosis target portion of the cable 40, or the like based on the geothermal conductivity. The controller 12 may acquire, as the timing of the temperature change, the time at which the temperature change starts or the time at which the rate of temperature change reaches a maximum value. The time at which the rate of temperature change reaches a maximum value is the time when the slope of the graph of temperature change becomes steepest. In a case in which, for example, point X is set as the diagnosis target portion and point Y is set as the portion other than the diagnosis target portion, the controller 12 may correct the value that represents the state of the diagnosis target portion of the cable 40 taking into consideration the state of the portion other than the diagnosis target portion of the cable 40, based on the difference between the timing of the change in temperature at point X serving as the diagnosis target portion and the timing of the change in temperature at point Y serving as the portion other than the diagnosis target portion.

The accuracy of diagnosis of the state of the cable 40 is improved by taking into consideration the heat generated by the cable 40 as described above.

### <Diagnosis in Case of no Current Flowing in Cable 40>

As described above, the controller 12 may correct the danger level, the value that represents the state of the diagnosis target portion of the cable 40 taking into consideration the state of the portion other than the diagnosis target portion of the cable 40, or the like taking into consideration the heat generated by the cable 40. In a case in which no current is flowing in the cable 40, the cable 40 does not generate heat. In the case of no heat generation by the cable 40 as well, the controller 12 may correct the danger level, the value that represents the state of the diagnosis target portion of the cable 40 taking into consideration the state of the portion other than the diagnosis target portion of the cable 40, or the like taking into consideration other information.

The temperature of seawater changes in a daily cycle. The controller 12 may correct the danger level of each portion of the cable 40, the value that represents the state of the diagnosis target portion of the cable 40 taking into consideration the state of the portion other than the diagnosis target portion of the cable 40, or the like based on the difference between the change in temperature of seawater and the change in temperature of each portion of the cable 40. When electricity is not flowing for a long period, such as during construction, the controller 12 may correct the danger level of each portion of the cable 40, the value that represents the state of the diagnosis target portion of the cable 40 taking into consideration the state of the portion other than the diagnosis target portion of the cable 40, or the like based on not only one day's data but also long-term data.

In a case in which the cable 40 is buried deep in the ground 80, the temperature of each portion of the cable 40 is less susceptible to the daily changes in the temperature of seawater. On the other hand, the temperature of seawater may also change over an annual cycle, for example due to the change of seasons or meandering ocean currents. The controller 12 may correct the danger level of each portion of the cable 40, the value that represents the state of the diagnosis target portion of the cable 40 taking into consideration the state of the portion other than the diagnosis target portion of the cable 40, or the like based on the difference between the moving average of the temperature of seawater and the moving average of the temperature of each portion of the cable 40. Specifically, the controller 12 may calculate the difference between the timing at which the slope of the moving average of the temperature of seawater reverses and the timing at which the slope of the moving average of the temperature of each portion of the cable 40 reverses. The controller 12 may correct the danger level of each portion of the cable 40, the value that represents the state of the diagnosis target portion of the cable 40 taking into consideration the state of the portion other than the diagnosis target portion of the cable 40, or the like using the difference in the timing at which the slope of the moving average of the temperature of each portion of the cable 40 reverses as a parameter inversely proportional to the geothermal conductivity.

### <Specific Example of Correction Using Geothermal Conductivity>

The controller 12 may correct a parameter used in the diagnosis of each portion of the cable 40, such as the danger level of each portion of the cable 40, the value that represents the state of the diagnosis target portion of the cable 40 taking into consideration the state of the portion other than the diagnosis target portion of the cable 40, or the like based on the geothermal conductivity of the area where each portion of the cable 40 is buried. The controller 12 may set a parameter for the geothermal conductivity in each of the cells into which the cable 40 is finely divided by region. The group of parameters is also referred to as a profile. The controller 12 may associate positional information for the cable 40 with burial information, such as the burial depth of the cable 40, and time as characteristic data. The positional information for the cable 40 may, for example, include a distance from the temperature measurement apparatus 20. The controller 12 may associate the positional information for the cable 40 with time, the temperature at that position of the cable 40, the voltage applied to the cable 40, and the electric current flowing through the cable 40 as historical data. The controller 12 may associate positional information for the cable 40 with the ground type and geothermal conductivity as historical data. The controller 12 may associate the positional information for the cable 40 with the assumed burial depth, long-term rate of change, short-term rate of change, and degree of abnormality as historical data.

The temperature measurement apparatus 20 outputs the measured temperature value and the distance to the point where the measured temperature value was obtained. Here, the voltage and electric current, along with the amount of heat generated by the cable 40, are the same in each cell of the cable 40 if a voltage drop is considered as an error. Therefore, the measured amount of heat dissipation and measured temperature value for each cell of the cable 40 having the same or a similar profile are the same. Profiles that are the same or similar are assumed to be identified by the same or similar depth and the same or similar thermal conductivity. Even if the electricity transmitted by the cable 40 changes, the amount of heat generation and the amount of heat dissipation of the cable 40 follow suit, so that cells with the same or similar profiles will have the same or similar heat generation pattern.

On the other hand, in the initial burial state, when the burial depth of the cable 40 does not change much, differences in the change in temperature may occur due to following of the current. In the case of cable burial at a certain depth, differences in the change in temperature are due to geothermal conductivity. The geothermal conductivity of each cell is then corrected by calculating backward from the difference in the change in temperature. If the burial depth is deep enough, thermal convection need not be taken into consideration. The correction value of the geothermal conductivity may be calculated as ratio data or as a bias. The correction value for the geothermal conductivity may be stored for each subsurface type.

### <Determination of Exposed Portion>

The submarine cable has portions that are intentionally exposed from the ground 80 to the seabed 81. The amount of heat dissipation inside the ground 80 is mainly determined by the thermal conductivity of the ground 80. On the other hand, there is a point where the amount of heat dissipation increases rapidly before approaching the portion exposed to the seabed 81. This point is located near the exposed portion 52. One means for identifying the exposed portion of the cable 40 is to check the location exposed to the seabed 81 against the positional information from installation work information and the like and compare the change in temperature at that position.

The exposed portions may be identified by calculation. At shallow burial locations, thermal radiation is predominantly thermal conduction, radiation, and convection. On the other hand, at exposed locations, the amount of heat dissipation increases rapidly due to the elimination of thermally conductive areas with a low amount of heat dissipation. Based on this relationship, the temperature of cells buried shallower than a certain depth will gradually decrease compared to the temperature of cells that have the same or a similar profile and are buried deeper. Furthermore, the temperature further decreases when convection becomes dominant instead of heat conduction for reasons such as exposure to the seabed 81. A portion where the temperature decreases may therefore be determined to be an exposed portion.

### <Other Examples of Diagnosis Targets>

The diagnostic system 1 is not limited to the submarine cable of the offshore wind power generation apparatus 70 described above and may be applied to diagnosis of the state of various other cables 40. For example, the diagnostic system 1 may be applied to diagnosis of the state of submarine cables for providing power or communication to remote islands or the like. The diagnostic system 1 may be applied to diagnosis of the state of a cable 40 laid on land. For example, the diagnostic system 1 may be applied to diagnosis of the state of a cable 40 that is on land but is buried in the ground, or a cable 40 that is laid in areas where it is difficult for humans to enter, such as mountainous areas. The diagnostic system 1 may be applied to diagnosis of the state of deterioration of a cable 40. The diagnostic system 1 may be applied to diagnosis of the state of flooding of a cable 40.

Although embodiments of the present disclosure have been described through drawings and examples, it is to be noted that various changes and modifications may be made by those skilled in the art on the basis of the present disclosure. Therefore, such changes and modifications are to be understood as included within the scope of the present disclosure. For example, the functions and the like included in the various components may be reordered in any logically consistent way. Furthermore, components may be combined into one or divided.

### REFERENCE SIGNS LIST

1 Diagnostic system
10 Diagnostic apparatus (12: controller, 14: memory, 16: interface)
20 Temperature measurement apparatus
30 Display apparatus
40 Cable (41: power line, 42: optical fiber, 43: sheath, 45: exposure start portion, 51: buried portion, 52: exposed portion, 53: buried portion, 54: shallow buried portion, 55: boundary portion)
70 Offshore wind power generation apparatus
80 Ground
81 Seabed
82 On land
84 In the sea
85, 86 Ocean current

## Claims

1. A diagnostic method for diagnosing a state of a cable including a diagnosis target portion and a portion other than the diagnosis target portion,
the diagnosis target portion corresponding to a part of a measurement target portion for measuring a temperature of the cable,
the portion other than the diagnosis target portion corresponding to a different measurement target portion than the measurement target portion corresponding to the diagnosis target portion,
the diagnostic method comprising:
acquiring a measured temperature value at the measurement target portion corresponding to the diagnosis target portion of the cable as a temperature of the diagnosis target portion of the cable;
acquiring a measured temperature value at the measurement target portion corresponding to the portion other than the diagnosis target portion of the cable as a temperature of the portion other than the diagnosis target portion of the cable; and
determining that a state of the diagnosis target portion is abnormal in a case in which an amount of change in the temperature of each of the diagnosis target portion and the portion other than the diagnosis target portion of the cable satisfies a diagnostic condition applied to diagnosis based on a change over time in the temperature of each of the diagnosis target portion and the portion other than the diagnosis target portion of the cable, and the temperature of the diagnosis target portion of the cable satisfies a diagnostic condition applied to diagnosis based on the temperature of the diagnosis target portion of the cable.

2. The diagnostic method according to claim 1, comprising determining, after determining that the amount of change in the temperature of each of the diagnosis target portion and the portion other than the diagnosis target portion of the cable satisfies the diagnostic condition applied to diagnosis based on the change over time in the temperature of each of the diagnosis target portion and the portion other than the diagnosis target portion of the cable, whether the temperature of the diagnosis target portion of the cable satisfies the diagnostic condition applied to diagnosis based on the temperature of the diagnosis target portion of the cable.

3. The diagnostic method according to claim 2, comprising changing the portion other than the diagnosis target portion to a different portion of the cable so that the amount of change in the temperature of each of the diagnosis target portion and the portion other than the diagnosis target portion of the cable satisfies the diagnostic condition applied to diagnosis based on the change over time in the temperature of each of the diagnosis target portion and the portion other than the diagnosis target portion of the cable.

4. The diagnostic method according to claim 1, wherein
the diagnostic condition applied to diagnosis based on the change over time in the temperature of each of the diagnosis target portion and the portion other than the diagnosis target portion of the cable includes a condition based on a value that represents the state of the diagnosis target portion taking into consideration a state of the portion other than the diagnosis target portion of the cable, the value being calculated based on the amount of change in each of the temperature of the diagnosis target portion of the cable and the temperature of the portion other than the diagnosis target portion of the cable, and
the diagnostic condition applied to diagnosis based on the temperature of the diagnosis target portion of the cable includes a condition based solely on the change over time in the temperature of the diagnosis target portion.

5. The diagnostic method according to claim 4, wherein
the condition based solely on the change over time in the temperature of the diagnosis target portion includes the temperature of the diagnosis target portion of the cable being outside a determination range, and
the determination range is set based on a magnitude of an electric current flowing in the cable and an environment surrounding the diagnosis target portion of the cable.

6. The diagnostic method according to claim 4, wherein
the value that represents the state of the diagnosis target portion taking into consideration the state of the portion other than the diagnosis target portion of the cable is calculated as an absolute value of a difference between a value obtained by multiplying the amount of change in the temperature of the diagnosis target portion of the cable by a coefficient corresponding to the diagnosis target portion of the cable and a value obtained by multiplying the amount of change in the temperature of the portion other than the diagnosis target portion of the cable by a coefficient corresponding to the portion other than the diagnosis target portion of the cable,
the coefficient corresponding to the diagnosis target portion of the cable is set based on an environment surrounding the diagnosis target portion of the cable,
the coefficient corresponding to the portion other than the diagnosis target portion of the cable is set based on an environment surrounding the portion other than the diagnosis target portion of the cable,
the condition based on the value that represents the state of the diagnosis target portion taking into consideration the state of the portion other than the diagnosis target portion of the cable includes the value that represents the state of the diagnosis target portion taking into consideration the state of the portion other than the diagnosis target portion of the cable being equal to or greater than a determination value, and
the determination value is set based on the coefficient corresponding to the diagnosis target portion of the cable and the coefficient corresponding to the portion other than the diagnosis target portion of the cable.

7. The diagnostic method according to claim 4, wherein the value that represents the state of the diagnosis target portion taking into consideration the state of the portion other than the diagnosis target portion of the cable is corrected based on a difference between a time at which the temperature of the diagnosis target portion of the cable begins to change and a time at which the temperature of the portion other than the diagnosis target portion of the cable begins to change.

8. A diagnostic program configured to cause a computer to execute the diagnostic method according to any one of claims 1 to 7.

9. A diagnostic apparatus comprising a controller configured to execute the diagnostic method according to any one of claims 1 to 7.
